# EUROPEAN PATENT APPLICATION

(11) **EP 3 843 120 A1**
(43) Date of publication of application: **30.06.2021**
(21) Application number: 19219423.1
(22) Date of filing: 23.12.2019
(51) Int. Cl.: H01J 37/20, H01J 37/295

(54) **SAMPLE HOLDER FOR ELECTRON DIFFRACTION EXPERIMENTS WITH GONIOMETER AND CONTACT COOLING**

(71) Applicant: University of Vienna, 1010 Vienna (AT)
(72) Inventor: Grüne, Tim, 1090 Wien (AT)
(74) Representative: Karl, Christof

(57) **Abstract**

The present invention relates to a longitudinal sample holder for electron diffraction experiments, wherein the holder is both rotatable and translatable; optionally with a goniometer and contact cooling.

## Description

### Technical field

The present invention relates to a sample holder for electron diffraction experiments with goniometer and contact cooling. More specifically, the present invention relates to a longitudinal sample holder wherein the holder is both rotatable and translatable.

### Background

Electron diffraction (ED) experiments currently use transmission electron microscopes (TEM). The sample holder is a metal rod, optionally with a reservoir at the outside end for liquid nitrogen (or helium or else) cooling of the sample. The inside end is inserted into the TEM by feeding the rod through a goniometer, i.e. the rotational movement of the sample holder is carried out by rotating the entire holder, translational movement is mimicked by a tilt about a pivot point approximately at the level of the outside housing of the TEM.

With conventional sample holder which are generally relatively large and immobile in their entirety, the sample can often only rotated by about +/-70 degrees as it will otherwise hit the pole shoes of an electromagnetic lens. With conventional sample holders and goniometers attached to the housing, rotation and translation of the sample are not independent, and the sample cannot be placed onto the rotation axis of the goniometer very accurately: during 100 degree rotation, the specimen on the sample holder often rotates out of the field of view, which as typically 1.5 to 2 micrometre diameter. Furthermore, the limitation rotation range prevents fast centring of the specimen.

### Summary of the invention

The present invention solves the aforementioned drawbacks of the prior art by combining the sample holder with the goniometer and detaching the goniometer from the TEM housing.

The present invention is defined by the features of the independent claim(s). Preferred advantageous embodiments thereof are defined by the sub-features of the dependent claims.

The movement enabled by the present invention results in independent movement of the rotation and of the translation. It also results in improved accuracy with respect to the requirements of electron crystallography, i.e. the data collection based on the rotation method (Arndt & Wonacott, 1977): the sample has to stay in the field of view (typically 1.5 to 2 micrometres diameter) during rotation for as long as possible.

The solution of the present invention advantageously enables data collection from both sides of the crystal, which increases data multiplicity (and therefore data quality). The design of the present invention also enables extremely quick centring of the sample, electronically controlled with a few mouse clicks at a computer screen. This beneficially reduces radiation damage by reducing the time required to centre the sample and reduces search time and thus reducing radiation damage to the sample and increasing throughput of the sample.

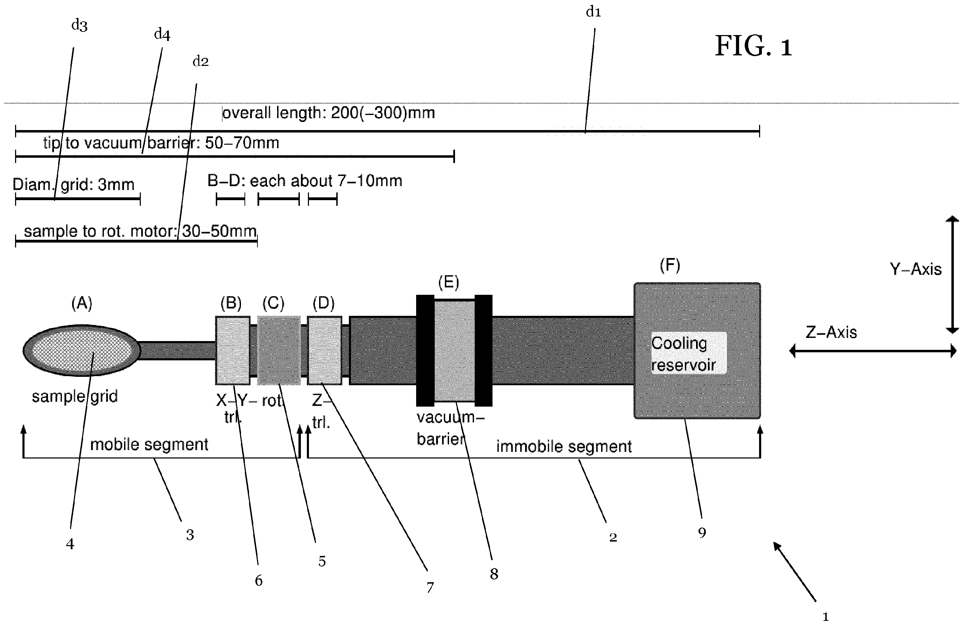

The solution of the present invention thereby improves flexibility and accuracy by allowing for a true x-y-z translation of the sample, and a rotation of the sample without moving the rest of the sample holder, in particular without moving the reservoir for liquid nitrogen. According to the present invention, single axis rotation about the (z-)axis of the sample holder is enabled (see, for example, Fig. 1).

In a preferred example, the z-translation may optionally be separated from the x-y-translation by an individual motor.

According to the invention, a sample holder is provided for electron diffraction experiments on specimens, for example crystals, wherein the sample holder comprises a longitudinal body which comprises an immobile portion and a mobile portion. The mobile portion comprises holding means for holding a sample, rotation means to rotate the holding means and translation means configured to translate the holding means. The sample holder of the invention not only advantageously enables data collection from both sides of the sample, but also enables accurate translation in x- and/or y- and/or z-directions. The present invention thereby increases the sample data which can be measured and thereby improves accuracy. Furthermore, the present invention enables quick computer-controlled centring of the sample. The present invention additionally enables actual translation movement of the sample and thereby avoids tilting about a pivot point which might lead to inaccurate results.

According to an example sample holder of the invention, the mobile portion is attached to a first end of the immobile portion. By forming the mobile portion and immobile portion as discrete devices which are couplable, this example enables flexibility in use and convenient maintenance.

According to another example sample holder of the invention, the rotation means and translation means are integral. By providing a single means, this example simplifies design of the sample holder by having a single means for rotation in the x- and y-directions and translation in x-, y- and z-directions.

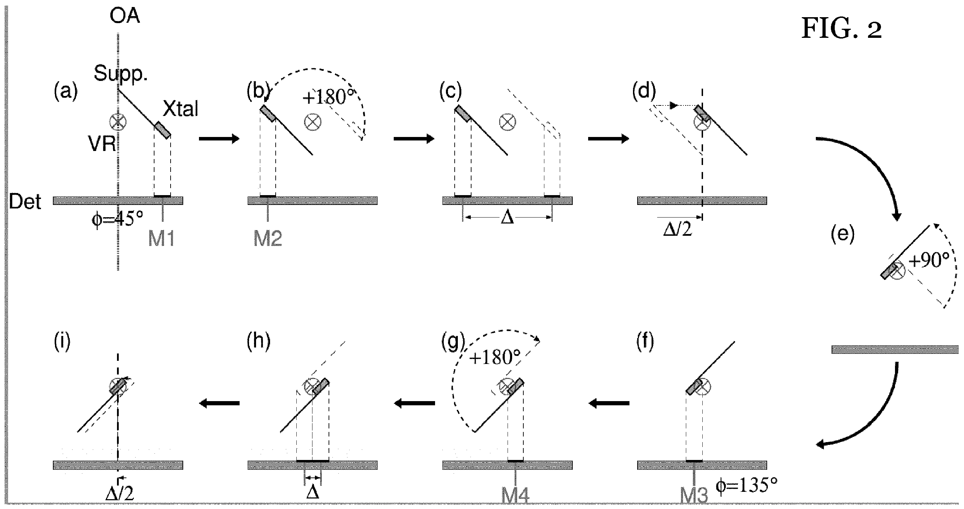

According to a further example sample holder of the invention, the rotation means and translation means are discrete from one another. By providing individual motors for each of the rotation and translation means, this example enables greater control of movement to be achieved and thereby higher accuracy in the angles at which measurements may be taken. This also ensures fast and accurate centring of the sample as explained in more detail with respect to Fig. 2.

According to a further example sample holder of the invention, the rotation means is configured to rotate 360 degrees around the (z-)axis of the longitudinal body. This enables full analysis of a sample around the z-axis.

According to a further example sample holder of the invention, the rotation means is configured to rotate in increments of between 0.1 and 3 degrees per second around the (z-)axis of the longitudinal body. This allows for the data collection strategy to be adapted to the intensity of the probing electron beam and the strength of the signal recorded from the specimen. The goniometer according to the invention may further have a means to correct the rotational speed in order to keep it constant during the rotation which further improves the accuracy of results.

According to a further example sample holder of the invention, the translation means is configured to translate within a range of 2mm in the x- and/or y- and/or z- direction with respect to the longitudinal body. Together with the aforementioned 360 degree rotation, this example enables full analysis of a sample in x-, y- and z-directions.

According to a further example sample holder of the invention, a second end of the immobile portion is configured to be attached to a cooling reservoir. This enables facilitated liquid nitrogen (or helium etc.) cooling of the sample.

According to a further example sample holder of the invention, the rotation means comprises a goniometer. By making the goniometer an integral part of the sample holder, this example enables precise measurement of the angle of the holding means and therefore of the sample.

According to a further example sample holder of the invention, the mobile portion enables measurement within a range of 100 to 500nm accuracy. By having a goniometer specifically according to the arrangement of examples of the present invention, it reduces the amount by which the sample holder blocks the electron beam, thereby increasing the number of angles at which the sample can be experimented on in all x-y-z directions and hence improves the number of measurements possible and the accuracy of the results.

In another aspect of the present invention, a system is provided comprising a transmission electron microscope and the sample holder according to any of the aforementioned examples.

In a further aspect of the invention, a method for optical centring of a sample is provided using the sample holder of any one of the aforementioned examples, the method comprising one or more of the steps described in further detail below with respect to Figs. 2(a) to 2(i).

### Preferred implementation of the invention

Fig. 1 illustrates a sample holder 1 according to a preferred implementation of the invention. The sample holder 1 is in the form of a longitudinal body which includes an immobile portion 2 and a mobile portion 3 attached to the immobile portion 2. The overall length d1 of the sample holder 1 is preferably between about 200 and 300mm, preferably about 200mm.

The mobile portion 3 includes a holder 4 for holding a sample such as one or more crystal(s) for analysis.

The holder 4 preferably comprises a grid of a thermally conductive material. The mobile portion 3 further includes a rotation means 5 and a translation means 6 for rotating and translating the holder 4.

Rotation means 5 and translation means 6 may either be integral i.e. comprise a single motor configured to rotate and/or translate the holder 4 in x-, y- and/or z-directions, or comprise a plurality of motors i.e. rotation means 5 comprising a first motor configured to rotate the holder 4 around the longitudinal axis of the sample holder 1 and a second motor attached to the first motor and configured to translate the holder in the x- and y-directions. Both the first rotational motor 5 and the second X-Y translational motor 6 are preferably high precision motors, each with a height or width of about 7 to 10mm. In a further example, a further third motor 7 is preferably provided and which may be either part of the mobile portion 3 or immobile portion 4 and is configured to translate the mobile portion 3 along the z-axis in a longitudinal direction. The Z translational motor 7 is also preferably a high precision motor with a height or width of about 7 to 10mm.

The distance d2 between the motors and the holder 4 is preferably between 30 to 50 mm but depends on the so-called "pole shoes" of the electron microscope. These are a pair of electromagnets above and below the sample which are separated by about 1cm (vendor specific), while motors have edges of about 5cm, i.e. there must be a separation along the rotation axis. The shorter this distance, the greater the precision of the instrument, as a precession due to the rotation of the rotational motor (C) results in a smaller travel distance at the sample position.

In operation, a sample (such as one or more crystals) is placed on the grid of the holder 4. The sample grid of the holder 4 preferably has a diameter d3 of 2 to 3mm. The holder 4 is preferably coupled to the sample holder 1 with a spring mechanism (not shown). The sample holder 1 is inserted horizontally into the housing of a TEM via a vacuum barrier 8 such that the holder 4 is at the position of the optical axis (i.e. the electron beam) of the system. The distance d4 between the tip of the holder 4 to the vacuum barrier is preferably about 50 to 70mm.

A cooling reservoir 9 is attached to the end of the sample holder 1 external to the TEM housing to enable cooling of the sample on the holder 4. The cooling reservoir 9 preferably comprises a tank of liquid nitrogen and further preferably comprises a metal bar or inner tube, that is flooded with the liquid nitrogen, leading towards the holder 4. In a further preferred example, part of the cooling reservoir 9 may be replaced by a piezo element.

The vacuum barrier 8 is preferably a rubber O-ring. In a preferred embodiment of the invention, only the mobile portion 3 of the sample holder 1 is inserted into the TEM housing and the non-rotatable and non-translatable immobile portion 2 is external to the TEM housing. Such an arrangement advantageously allows for more sophisticated vacuum barriers which, for example, enable reduced insertion time, and/or allow for a better protection of temperature/air sensitive samples. Conventional sample holders, especially cryo-holders take a long time to insert into TEM housings because the vacuum for the cooling reservoir has to be pumped empty by the vacuum pump of the electron microscope. Such a process can normally take between 30 to 45 minutes between sample loading and investigation of the sample.

Figs. 2(a) to 2(i) illustrates an example of an optical centring process performed with a sample holder 1 according to the aforementioned implementation of Fig. 1. The following is a summary of features that refer to all sub-figures 2(a) to 2(i):
**OA:** optical axis (dashed line running through the middle of Figs. 2(a) to (i)), runs parallel to the electron beam of the transmission electron microscope, the electrons run from top to bottom. The electron beam produces a projection on the detector plane.
**VR:** virtual rotation axis (cross in a circle in the centre of Figs. 2(a) to (i)). The process described below is composed of a rotational and a translational movement. The rotational movement runs about a virtual axis which cannot be seen. The process places the specimen onto this axis. For this to work it is important that the motor for the translational movement is placed between the motor for the rotational movement and the specimen. Otherwise, the translational movement would change the position of the virtual axis.
**Det:** detector plane (rectangle at the bottom of Figs. 2(a) to (i)). A detector is often pixelated and shows the image with 1024x1024 pixels, each a square with 75 micrometre edges. It is placed about 400-800mm below the sample stage. The detector does not form part of the invention but is necessary for the process and incorporated herein in order to facilitate understanding of the invention. In Figs. 2(a) to (i), it is assumed that the detector plane is perpendicular to the optical axis. This facilitates the description of the process, but it is not a requirement.
**Xtal:** crystal (small rectangular block attached to the diagonal line indicating the sample support of the holder 4 described below in Figs 2(a) to (i)). This represents the crystal specimen under investigation. The purpose of the process described below is to bring the crystal onto the virtual rotation axis of the goniometer. The crystal typically has a thickness of 100-1000nm and a width and height of typically between 200nm to 2000nm.
**Supp:** Sample support (diagonal line in Figs. 2(a) to (i) which is connected to Xtal). The crystal is attached to the sample support of the holder 4. The sample support has a flat surface portion local to the crystal specimen. The crystal is moved together with the sample support during the transitional and the rotational movement. The sample support surrounding the crystal is transparent to the electron beam when the electron traverses perpendicular to the flat surface. The sample support is typically stabilised by a metal grid (copper, gold, or similar conductive metals). The electrons cannot traverse the supporting metal grid, with the consequence that there is an angle alpha-max, at which the electrons are blocked. alpha-max is typically +/- 70 degree rotated about the virtual rotation axis VR, starting from the position when the flat surface is perpendicular to the optical axis and parallel to the detector surface. A sample support is typically a grid with 3mm diameter, and a square metal grid. The grid holes (mesh) are about 50 micrometres x 50 micrometres. Although the crystal specimen may be placed anywhere inside such a mesh, it is ideally placed at its centre. The holding mechanism must be attached to the translational motor such that the plane of the sample support forms a 45 degree angle to the optical axis, when the translation moves perpendicular to the optical axis and parallel to the detector plane.
**M1 to M4:** marks (bars indicating a position in the detector plane in Figs. 2(a) to (i)). A feature of the crystal is marked on the detector plane, i.e., a record of the x- and y-pixel coordinate is made before the following movement.

According to the process illustrated in Fig. 2:
In Fig. 2(a) The rotational motor is placed such that the X-axis of the translational motor moves parallel to the detector plane and perpendicular to the optical axis. A feature of the crystal specimen that is easy to identify, e.g. a corner, is recorded/marked on the detector pixel coordinates as M1.
In Fig. 2 (b) the rotational motor rotates by 180 degrees. The new position of the feature is subsequently marked on the detector pixel coordinates as M2.
In Fig. 2 (c) the centre between the line M1 to M2 is marked on the detector.
In Fig. 2 (d) the translational motor moves the crystal / sample support along its X-axis such that the feature is placed at the centre position.
In Fig. 2 (e) The rotational motor rotates by 90 degrees. This makes the Y-axis of the translational motor run parallel to the detector plane, perpendicular to the optical axis.
In Fig. 2(f) A feature of the crystal specimen (not necessarily the same feature as mentioned with respect to Fig. 2(a)) is marked on the detector pixel coordinates as M3.
In Fig. 2 (g) the rotational motor rotates by 180 degrees. The new position of the feature is marked on the detector pixel coordinates as M4.
In Fig. 2(h) the centre between the line M3 to M4 is marked on the detector.
In Fig. 2(i) the translational motor moves the crystal / sample support along its Y-axis such that the feature is placed at the centre position.

This process brings the crystal into the rotational axis of the goniometer within the precision of the motors. During a subsequent rotation of the rotational axis, the projection of the crystal stays at the same position on the detector plane. When the precision of the goniometer lies within 500nm about the virtual rotation axis VR, the crystal moves at most 1000nm during the rotation. The beam diameter is typically 1000nm, so that data can be recorded during the rotation. When the distance between rotational motor and crystal is about 5cm, the rotational stability (precession angle) needs to be below 1 milli degree (20 mrad).

Higher precision of the motors advantageously result in a smaller beam diameter and thereby less noise in the data.

The process can be automated, i.e. the user can click on the feature displayed on the computer screen to mark M1 and M2, and the motors drive automatically. Likewise for positions M3 and M4. This minimises exposure time of the crystal (and thus its radiation damage) during the alignment process.

In combination with an independent Z-translation, the sample (crystal) can be moved out of the beam by a Z-translation of approximately -1000nm, before the process starts, and moved back by 1000nm just before data collection. This advantageously reduces the exposure of the crystal to the electron beam and thus limits radiation damage during the alignment process even further. Data collection can be started automatically once the crystal has been moved back and the rotation as started.

## Claims

1. A sample holder (1) for electron diffraction experiments comprising:
a longitudinal body, wherein the longitudinal body comprises:
an immobile portion (2); and
a mobile portion (3), wherein the mobile portion comprises:
holding means (4) for holding a sample;
rotation means (5) to rotate the holding means; and
translation means (6, 7) configured to translate the holding means.

2. The sample holder of claim 1, wherein the mobile portion is attached to a first end of the immobile portion.

3. The sample holder of claim 2, wherein the rotation means and translation means are integral.

4. The sample holder of claim 2, wherein the rotation means and translation means are discrete from one another.

5. The sample holder of any of the preceding claims, wherein the rotation means is configured to rotate 360 degrees around the (z-)axis of the longitudinal body.

6. The sample holder of any of the preceding claims, wherein the rotation means is configured to rotate in increments of between 0.1 and 3 degrees around the (z-)axis of the longitudinal body.

7. The sample holder of any of the preceding claims, wherein the translation means is configured to translate within a range of 2mm in the x- and/or y- and/or z- direction with respect to the longitudinal body.

8. The sample holder of any of the preceding claims, wherein a second end of the immobile portion is configured to be attached to a cooling reservoir.

9. The sample holder of any of the preceding claims, wherein the rotation means comprises a goniometer.

10. The sample holder of claim 9, wherein the mobile portion enables measurement within a range of 100 to 500nm accuracy.

11. A system comprising:
a transmission electron microscope; and
the sample holder of any one of claims 1 to 10.

12. A method for optical centring of a sample using the sample holder of any one of claims 1 to 10, the method comprising:
placing the rotational means such that the X-axis of the translation means moves parallel to a detector plane and perpendicular to an optical axis;
determining a feature of the sample and marking a first position (M1) of the determined feature on the detector plane.

13. The method of claim 12, further comprising:
rotating the rotation means by 180 degrees and marking a second position (M2) of the determined feature on the pixel coordinates of the detector;
determining a centre position between the first and second positions and marking the centre position on the detector.
moving the translation means to move the sample along its X-axis such that the feature is placed at the determined centre position.

14. The method of claims 12 or 13, further comprising:
rotating the rotation means by 90 degrees;
determining a further feature of the sample and marking a third position (M3) of the further feature on the detector plane;
rotating the rotational means by 180 degrees;
determining a fourth position (M4) of the determined further feature;
marking the fourth position on the detector plane; and
determining a second centre position between the third and fourth positions and marking the second centre position on the detector plane.
